# EUROPÄISCHE PATENTSCHRIFT

(11) **EP 3 548 909 B1**
(45) Veröffentlichungstag und Bekanntmachung des Hinweises auf die Patenterteilung: **06.04.2022**
(21) Anmeldenummer: 17791280.5
(22) Anmeldetag: 06.10.2017
(51) Int. Cl.: G01R 33/09, G01R 33/18

(54) **SENSORELEMENT FÜR MAGNETFELDER MIT HOHER FREQUENZBANDBREITE**
SENSOR ELEMENT FOR MAGNETIC FIELDS HAVING HIGH FREQUENCY BANDWIDTH
ÉLÉMENT DE DÉTECTION DE CHAMPS MAGNÉTIQUES À LARGEUR DE BANDE DE FRÉQUENCE ÉLEVÉE

(30) Priorität: 01.12.2016 DE 102016123274
(43) Veröffentlichungstag der Anmeldung: 09.10.2019
(73) Patentinhaber: Christian-Albrechts-Universität zu Kiel, 24118 Kiel (DE)
(72) Erfinder: QUANDT, Eckhard, 24226 Heikendorf (DE); KITTMANN, Anne, 24114 Kiel (DE); ZABEL, Sebastian, 24220 Schönhorst (DE); YARAR, Erdem, 24103 Kiel (DE); FAUPEL, Franz, 24226 Heikendorf (DE); KNÖCHEL, Reinhard, 25336 Elmshorn (DE); HÖFT, Michael, 24235 Laboe (DE); DURDAUT, Phillip, 24116 Kiel (DE)
(86) Internationale Anmeldenummer: PCT/DE2017/100848
(87) Internationale Veröffentlichungsnummer: WO 2018/099506

(56) Entgegenhaltungen:
- EP-A1- 1 548 702
- CN-A- 101 504 446
- JP-A- 2007 304 087
- US-A1- 2008 163 694
- US-A1- 2009 206 844
- MERIEM ELHOSNI ET AL: "Magnetic field SAW sensors based on magnetostrictive-piezoelectric layered structures: FEM modeling and experimental validation", SENSORS AND ACTUATORS A: PHYSICAL, Bd. 240, 1. April 2016 (2016-04-01), Seiten 41-49, XP055436545, NL ISSN: 0924-4247, DOI: 10.1016/j.sna.2015.10.031 in der Anmeldung erwähnt

## Beschreibung

Die Erfindung betrifft ein Magnetfeldsensorelement, in dem mittels elektrischer Erregung akustische Wellen im Sensormaterial angeregt werden, deren Ausbreitungsgeschwindigkeit von der Einwirkung eines externen Magnetfeldes abhängig ist. Die Erfindung betrifft insbesondere ein Sensorelement, in dem Surface Acoustic Waves (SAW) erzeugt werden.

Biomagnetische Felder werden durch bioelektrische Stromsysteme erzeugt, die in den Nervenleitungen lebender Organismen existieren. Sie können detektiert werden, um auf die Stromsysteme im Wege einer Rekonstruktion zurückzuschließen, beispielsweise um lokale Gehirnaktivitäten des Menschen zu ermitteln. Ein Fernziel ist die Entwicklung von Schnittstellen, die den gedachten Willen eines Menschen ohne Umweg über die sprachliche Formulierung in Maschinenbefehle übersetzen können. Nahe liegende erste Anwendungen liegen in den Bereichen Medizin, etwa zur Herstellung funktionaler Prothesen, und Militär, z.B. zur Waffenkontrolle.

Die biomagnetische Flussdichte ist grundsätzlich sehr schwach und muss mit einer Auflösung auf der Skala Pikotesla detektiert werden. Überdies liegen ihre wesentlichen Frequenzanteile im Intervall von unterhalb 1 bis oberhalb etwa 100 Hz.

Der Stand der Technik kennt SQUID-Sensoren, die diese Bereiche erfassen können, aber solche Sensoren sind aufgrund ihrer notwendig supraleitenden Komponenten auf extreme Kühlung angewiesen und somit weder kostengünstig noch anwenderfreundlich.

Sensoren auf Basis magnetoelektrischer (ME) Kompositmaterialen, auch ME-Sensoren genannt, haben das Potenzial massentauglicher Produzierbarkeit und können sehr schwache Magnetfelder detektieren. Es handelt sich bei ME-Sensoren jedoch um mechanische Oszillatoren, die es in ihrer Resonanz anzuregen gilt, um diese hohe Sensitivität zu erreichen. ME-Sensoren in MEMS-Bauweise besitzen Resonanzfrequenzen im hohen Kilohertz-Bereich und können nur mit zusätzlichen Maßnahmen zur Frequenzumsetzung, siehe z.B.

EP 2 635 913 B1, zur hohen Empfindlichkeit auch im biomagnetischen Frequenzbereich gebracht werden.

Demgegenüber sind Surface Acoustic Wave (SAW) Sensoren bekannt, die auch statische oder langsam veränderliche Magnetfelder detektieren können, indem sie akustische Wellen in ein magnetostriktives Material einkoppeln und die Ausbreitungsgeschwindigkeit der Wellen in diesem Material beobachten. Ausgenutzt wird hier die Änderung des Elastizitätsmoduls eines magnetostriktiven Materials in Anwesenheit eines Magnetfeldes, kurz als ΔE-Effekt bezeichnet. Die vom Magnetfeld hervorgerufene Änderung der Schallgeschwindigkeit kann beispielsweise bestimmt werden über die Messung der Phasenverschiebung der akustischen Welle, die von einem sendenden zu einem empfangenden Ultraschallwandler durch eine vorbestimmte Verzögerungsstrecke propagiert. Weitere Einzelheiten sind beschrieben in Bodong Li, Hommood AI Rowais and Jürgen Kosel (2013). Surface Acoustic Wave Based Magnetic Sensors, Modeling and Measurement Methods for Acoustic Waves and for Acoustic Microdevices, Prof. Marco G. Beghi (Ed.), InTech, DOI: 10.5772/55220. (Available from: http://www.intechopen.com/books/modeling-and-measurement-methods-for-acoustic-waves- and-for-acoustic-microdevices/surface-acoustic-wave-based-magnetic-sensors).

Aus dem Paper von Elhosni et al., "Magnetic field SAW sensors based on magnetostrictivepiezoelectriclayered structures: FEM modeling and experimental validation", Sensors and Actuators A 240 (2016) 41-49, ist ein aus mehreren Schichten gebildetes SAW-Magnetfeldsensorelement bekannt. Das Sensorelement ist als Resonator aufgebaut, der in Anwesenheit eines statischen Magnetfeldes eine Verstimmung der Resonanzfrequenz in Abhängigkeit der magnetischen Flussdichte erfährt. Die Schwingungen werden mit Radiowellen von einigen 100 MHz erregt, und die relative Verstimmung Δf/f wird in Einheiten ppm (parts per million) bestimmt. Als Empfindlichkeit ihres Sensors geben Elhosni et al. Werte um etwa 1 ppm/mT an.

Magnetische Induktionen der Größenordnung Mikro- oder gar Nanotesla sind mit den derzeit verfügbaren, auf Dünnschichttechnologie beruhenden SAW-Sensoren nicht zugänglich. Dies liegt vordergründig an der geringen Menge magnetischen Materials, die durch ein externes Magnetfeld die Schallausbreitung beeinflussen soll.

Aus dem Patent US 4,891,587 von Squire geht ein Magnetfeldsensor hervor, der nach demselben Prinzip der Schallgeschwindigkeitsänderung durch den ΔE-Effekt Flussdichten bis zur Größenordnung Pikotesla detektieren kann. Er besteht aus einem Streifen aus metallischem Glas, an den Piezotransducer gebondet sind. Der Streifen ist freitragend mit einer vorgesehenen Dicke zwischen 25 und 1000 Mikrometern, und die Erregungsfrequenzen liegen im korrespondierenden Intervall 0,1 bis etwa 100 MHz. Der Quotient aus Schallgeschwindigkeit (2600 m/s) und Erregungsfrequenz soll stets größer als die Streifendicke eingerichtet sein, damit sich bevorzugt Scherwellen im Streifen ausbreiten. Die Breite des Streifens beträgt 20 Millimeter, und die Transducer weisen einen Abstand von 200 Millimeter auf, was der Länge der Verzögerungsstrecke entspricht. Das Volumen des magnetischen Materials, das von den Schallwellen durchlaufen wird, ist bei dem Aufbau von Squire in etwa eine Million mal größer als bei dem von Elhosni et al., was die deutlich erhöhte Empfindlichkeit erklärt.

Allerdings kann ein Sensorelement nach Squire wegen seiner Dimensionen nicht ohne weiteres durch das Einstrahlen von Radiowellen erregt werden, wie man sich dies von SAW-Sensoren als passive Elemente zur Fernabfrage wünscht. Des Weiteren verhindert die Größe des Sensors Messungen mit einer hohen räumlichen Auflösung, wie sie z.B. für die Magnetokardiographie (MKG) oder die Magnetoenzephalographie (MEG) zur Lösung des inversen Problems - Lokalisierung des Stroms, der die gemessene Magnetfeldverteilung ausgelöst hat - notwendig sind.

Aus Zhou et al., "Theoretical and Experimental Study of Multilayer Piezo-magnetic Structure Based Surface Acoustic Wave Devices for High Sensitivity Magnetic Sensor", published in: Ultrasonics Symposium (IUS), 2013 IEEE International, p. 212-215 geht ein SAW-Magnetfeldsensor hervor, der eine 200 nm dicke Schicht aus TbCO₂/FeCo auf Lithiumniobat (LiNbO3) zu Rayleigh- und zu Scherwellen anregt, deren Geschwindigkeitsänderungen infolge eines angelegten Magnetfeldes untersucht werden. In dieser Arbeit wird die Änderung der elastischen Eigenschaften des magnetostriktiven Dünnfilms mit etwa 20 % beziffert. Diese Größenordnung des ΔE-Effekts wird durch die Arbeit von Ludwig und Quandt, publiziert in: Ludwig, A.; Quandt, E.: Optimization of the ΔE-effect in Thin Films and Multilayers by Magnetic Field Annealing, IEEE Trans. Magn. 38 (2002), 2829-2831 zu verschiedenen Dünnschichtsystemen bestätigt.

Aus der EP1 548 702 A1 ist eine Vorrichtung und ein entsprechendes Verfahren zur ultraschnellen Steuerung der Magnetisierung eines Magnetelements bekannt. Eine Vorrichtung enthält eine Einrichtung zur Erzeugung akustischer Oberflächenwellen, eine Transportschicht, die typischerweise funktionell und teilweise strukturell in der SAW-Erzeugungseinrichtung enthalten ist, und mindestens ein ferromagnetisches Element. Eine akustische Oberflächenwelle wird erzeugt und breitet sich in einer Transportschicht aus, die typischerweise aus einem piezoelektrischen Material besteht. Somit wird in der Transportschicht und in dem ferromagnetischen Element, das mit dieser Transportschicht in Kontakt steht, eine Verspannung induziert. Aufgrund der magnetoelastischen Kopplung wird im ferromagnetischen Element ein wirksames Magnetfeld erzeugt. Wenn die akustische Oberflächenwelle eine Frequenz hat, die im Wesentlichen nahe an der Frequenz der ferromagnetischen Resonanz (FMR) nu FMR liegt, wird das ferromagnetische Element gut absorbiert und der Magnetisierungszustand des Elements kann mit dieser FMR-Frequenz gesteuert werden. Das Gerät kann in einem HF-Magnetresonator, einem Sensor und einer Kamera eingesetzt werden. Das entsprechende Verfahren kann zum ultraschnellen Auslesen und Schalten von magnetischen Bauteilen und in der magnetischen Logik eingesetzt werden.

Die JP 2007 304087 A beschreibt einen akustischen Oberflächenwellensensor, umfassend einen Transponder, der ein akustisches Oberflächenwellenelement mit einem piezoelektrischen Substrat und einer Kammzahnelektrode und einer Antenneneinrichtung sowie eine Abfrageeinrichtung, die ein Ansteuersignal an den Transponder sendet und ein Antwortsignal vom Transponder empfängt. Auf dem piezoelektrischen Substrat ist eine magnetostriktive Membran vorgesehen. Eine auf das piezoelektrische Substrat einwirkende Spannung wird drahtlos auf der Grundlage der Änderung der Ausbreitungscharakteristik der akustischen Oberflächenwelle durch die magnetostriktive Membran erfasst.

Die US 2008/163694 A1 beschreibt eine akustische Erfassung unter Verwendung einer Brückenstruktur, die um einen Teil von mindestens zwei Seiten der Brücke mit einem Basissubstrat gekoppelt ist, wobei die Brücke einen piezoelektrischen Abschnitt enthält und mindestens einen aktiven akustischen Bereich in der Nähe der Brücke aufweist. Ein Erfassungsmaterial ist auf mindestens einem Teil von mindestens einer Oberfläche der Brücke angeordnet, wobei die Brücke Spannungseffekte erzeugt, die durch eine im aktiven akustischen Bereich befindliche Schallwellenvorrichtung messbar sind. Gemäß einer Ausführungsform werden die Spannungseffekte durch eine Schallwellenvorrichtung gemessen, um eine Zielsubstanz zu erfassen. Wenn sich Zielmoleküle auf einem Erfassungsfilm ansammeln, der an mindestens einem Teil der Brücke befestigt ist, wird in der Brücke eine Spannung erzeugt, die eine Frequenzänderung hervorruft, die von einer Schallwellenvorrichtung gemessen wird.

Die US 2009/206844 beschreibt einen Schallwellensensor, der eine elektromagnetische Vorrichtung (EMD), um die Reaktion eines Impedanzelements auf eine physikalische Messgröße zu übertragen und zu verstärken, verwendet. Eine Ausführungsform verwendet einen Magnetfeldsensor, der einen Kondensator eines mikroelektromechanischen Systems (MEMS) verwendet, um eine Änderung in der Reaktion eines SAW-Filters zu bewirken.

Die Erfindung CN 101 504 446 A offenbart einen in Schalloberflächenwellen integrierten Magnetsensor für ein Magnetfluid mit einer Dünnfilmstruktur, der ein piezoelektrisches Substrat, zwei Interdigitalwandler (IDT), einen Dünnfilm aus Magnetfluid und zwei Antennensätze zum Empfangen und Senden von Magnetwellensignalen umfasst. Die zwei Interdigitalwandler (IDT) sind jeweils an zwei Enden des Substrats positioniert. Der Magnetfluid-Dünnfilm wird in eine flache Rille zwischen den beiden Interdigitalwandlern auf der Oberfläche des Sensors eingefüllt und kapselt die Rille ein. Zwei Sätze der Antennen zum Empfangen und Senden der Magnetwellensignale sind jeweils mit Sammelschienen der beiden IDTs verbunden. Der Sensor kann eine passive drahtlose hochpräzise magnetische Intensitätsmessung in Echtzeit durchführen und ein Radiofrequenzsignal von den Antennen empfangen und eine horizontale scherende Schalloberflächenwelle auf den IDTs anregen. Die Reaktion des magnetischen Fluids ohne Verzögerung auf die Änderung eines äußeren Magnetfelds ändert augenblicklich die Verzögerungszeit der Schalloberflächenwellen-Verzögerungslinie, d. h die Viskositätsänderung des magnetischen Fluids ändert die Wellengeschwindigkeit der Schallwelle und wandelt die Schalloberfläche um Welle, die einer Schallgeschwindigkeitsänderung ausgesetzt ist, wandelt sich durch die IDTs in eine magnetische Welle um und überträgt die magnetische Welle durch die Antennen.

Die Erfindung stellt sich die Aufgabe, einen Magnetfeldsensor nach Art eines SAW-Sensors vorzuschlagen, der über eine verbesserte Magnetfeldsensitivität gegenüber dem Stand der Technik verfügt.

Die Aufgabe wird gelöst durch ein Magnetfeldsensorelement umfassend ein piezoelektrisches Substrat mit vorbestimmter Scherwellengeschwindigkeit V_{S}, zwei auf dem Substrat an den Enden einer Verzögerungsstrecke angeordnete Paare von Interdigitalelektroden mit einer Periodenlänge p von wenigstens 10 Mikrometern, eine auf dem Substrat entlang der Verzögerungsstrecke angeordnete, nicht-magnetische, elektrisch nicht-leitende Führungsschicht und eine auf der Führungsschicht angeordnete magnetostriktive Funktionsschicht, wobei die Scherwellengeschwindigkeit in der Führungsschicht kleiner als V_{S} ist, dadurch gekennzeichnet, dass das Substrat orientiert ist zur Erzeugung und Propagation von mechanischen Scherwellen bei Beaufschlagung wenigstens eines Interdigitalelektrodenpaares mit einer zeitlich periodischen, elektrischen Spannung im Bereich der Frequenz V_{S}/p und die Dicke der Führungsschicht mindestens 10 % und höchstens 30 % der Periodenlänge p der Interdigitalelektroden beträgt.

Das Konzentrieren der akustischen Welle in der Funktionsschicht wird erreicht durch das Vorsehen einer Führungsschicht auf dem Substrat, die eine kleinere Schallgeschwindigkeit als das Substrat aufweist. Als sehr vorteilhaft wird dabei angesehen, dass überdies die Dichte des Materials der Führungsschicht kleiner ist als die Dichte des Substratmaterials und die Führungsschicht geringe akustische Verluste aufweist.

Für die Messung von Magnetfeldgradienten wird zu je zwei Paaren von Interdigitalelektroden an den Enden einer Verzögerungsstrecke ein drittes Paar von Interdigitalelektroden in der Mitte der Verzögerungsstrecke angeordnet. Dieses mittlere IDE-Paar ist nun zum Anlegen der Anregungsspannung vorgesehen, während die beiden außen liegenden IDE-Paare als Detektoren der akustischen Wellen fungieren. Dadurch liegen hier praktisch zwei verschiedene Verzögerungsstrecken in unmittelbarer Nachbarschaft zueinander entlang der Richtung der Verzögerungsstrecke vor, die auch lokale Unterschiede des externen Magnetfeldes - mithin einen Gradienten - erfassen können. Der Schichtaufbau ist im Übrigen derselbe wie zuvor beschrieben, d.h. es bilden sich auch hier Love-Moden aus.

Die Unteransprüche geben vorteilhafte Ausgestaltungen an. Der Nebenanspruch 9 ist auf ein Magnetfeldsensorelement gerichtet, das als Resonator ausgebildet ist.

Den Ausgangspunkt der Erfindung bildet die Arbeit von Elhosni et al., in der ein Sensorelement mit folgenden Komponenten vorgestellt wird:
Das Substratmaterial ist Lithiumniobat (LiNbO3) (Schallgeschwindigkeit 4112 m/s). Auf dem Substrat angeordnet sind Interdigitalelektroden (IDE) aus Aluminium gebildet mit einer Periodenlänge von 24 Mikrometer. Auf dem Substrat und die IDE überdeckend ist eine Zinkoxid (ZnO) Schicht (die Schallgeschwindigkeit ist mit 2747 m/s kleiner als die von Lithiumniobat) Schicht mit einer Dicke von 250 Nanometern aufgebracht, um die IDE von der metallischen Funktionsschicht elektrisch zu isolieren. Die auf der ZnO-Schicht angeordnete magnetostriktive Funktionsschicht besteht aus elementarem Nickel und ist 200 Nanometer dick.

Der Sensor von Elhosni et al. ist als Resonator konzipiert und weist insofern keine Verzögerungsstrecke auf. Die vorgenannten Komponenten können aber ohne weiteres auch bei einem Sensor mit Verzögerungsstrecke verwendet werden.

Elhosni et al. untersuchen ihren Aufbau experimentell und theoretisch mittels Finite-Elemente-Methoden. Sie gehen von der Erregung von akustischen Rayleigh-Moden in ihrem Schichtsystem aus, die eine Materialbewegung auch senkrecht zu den Schichtebenen mit sich bringen. Die größten Amplituden werden dabei nahe der Oberfläche, also in der Funktionsschicht erwartet. Gleichwohl bewegt sich die akustische Welle überwiegend nicht durch das magnetostriktive Material, kann also für diesen Anteil keinen Einfluss durch ein externen Magnetfeldes spüren.

Elhosni et al. sehen Verbesserungspotenzial für die Sensitivität ihres Sensors darin, die Energie der akustischen Welle stärker in der Funktionsschicht zu konzentrieren. Als Maßnahmen schlagen sie u.a. vor, die elektrisch isolierende Schicht zwischen Substrat und Funktionsschicht aus einem Material mit einer höheren Schallgeschwindigkeit zu bilden. Die Schichtdicken werden hingegen als bereits optimiert angesehen.

Die vorliegende Erfindung weist nun in die eher entgegengesetzte Richtung.

Mit Blick auf den Sensor von Squire, dessen Sensitivität für Magnetfeldfrequenzen unterhalb von 1 kHz als besonders hoch berichtet wird, erscheint es attraktiv, gerade auch für die Messung biomagnetischer Felder, auf die Erregung und Ausbreitung von Scherwellen durch die Funktionsschicht zu setzen, die Materialbewegungen allein in der Schichtebene bewirken.

Solche auch als Love-Moden bezeichneten Wellen lassen sich gezielt anregen, indem man erfindungsgemäß geeignete Schnittflächen der piezoelektrischen Substrate auswählt, auf denen die IDE angeordnet werden. Für Lithiumniobat oder Lithiumtantalat sind dies beispielsweise die 36°YX Schnitte, und für Quarz sind die sogenannten AT und ST Schnitte verwendbar.

Erfindungsgemäß soll dabei die Dicke der Führungsschicht wenigstens 10 % und höchstens 30 % der akustischen Wellenlänge betragen. Die akustische Wellenlänge wird dabei durch die Periodenlänge der IDE festgelegt und stimmt mit dieser überein.

Grundsätzlich werden außer der Grundmode auch höhere harmonische Moden angeregt, und insbesondere kann die Anregung höherer Harmonischer gezielt durch die Wahl der elektrischen Anregungsfrequenz erfolgen und ebenfalls zur Auslesung genutzt werden. Allerdings bestimmt die Wahl der Dicke der Führungsschicht wesentlich mit, welche Wellenlängen mit welcher Dämpfung in der Führungsschicht propagieren können.

Will man Love-Moden erzeugen, so muss die Dicke der Führungsschicht deutlich kleiner sein als die propagierende Wellenlänge, was im erfindungsgemäßen Fall für die höheren - ungeraden - harmonischen Moden in der Regel nicht gut erfüllt ist, weil sich die Dicke der Führungsschicht erfindungsgemäß an der Grundmode, deren Detektion vorrangig beabsichtigt ist, orientiert. Die Wellenlänge der Grundmode wird hier durch die Periodenlänge der IDE zu mindestens 10 Mikrometer vorbestimmt, und die Führungsschicht ist erfindungsgemäß wenigstens 1 Mikrometer dick.

Es ist hervorzuheben, dass die Zinkoxidschicht auf dem Sensor nach Elhosni et al. in erster Linie als Isolationsschicht gedacht ist und erst zweitrangig als ein Mittel zur Konzentration der Welle in der Funktionsschicht. Für die Konzentration von Love-Moden nach der vorliegenden Erfindung ist sie bei der von Elhosni et al. benutzten Wellenlänge von 24 Mikrometern auf jeden Fall um mindestens eine Größenordnung zu dünn.

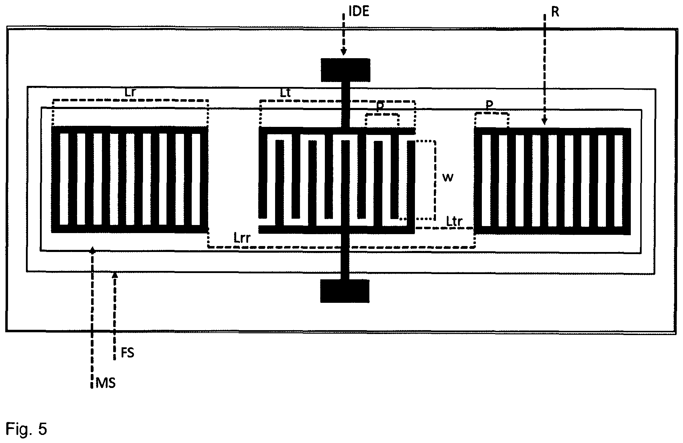

Die Erfindung soll im Folgenden näher erläutert werden, auch anhand von Figuren und einem Ausführungsbeispiel. Es wird darauf hingewiesen, dass der Schutzumfang der vorliegenden Erfindung durch die Ansprüche definiert ist. Daher beschränkt sich die vorliegende Erfindung u. a. auf Ausführungsformen, die ein drittes Paar von Interdigitalelektroden besitzen, wie es bspw. in Fig. 5 gezeigt ist. Dabei zeigt:
Fig. 1 die Skizze einer Love-Mode;
Fig. 2 die Skizze eines Magnetfeldsensorelements mit Verzögerungsstrecke;
Fig. 3 die Skizze einer Doppelfinger-IDE ;
Fig. 4 die Skizze eines Magnetfeldsensorelements aufweisend eine Funktionsschicht und eine Referenzschicht;
Fig. 5 die Skizze eines Magnetfeldsensorelements als Resonator;
Fig. 6 einen Plot erster Messergebnisse mit einem Prototypen.

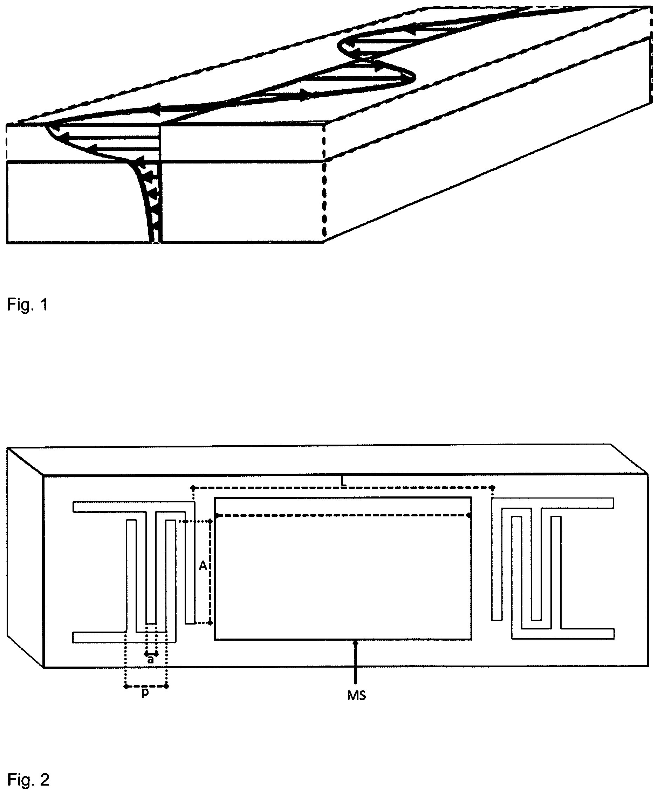

In Fig. 1 ist ein typischer Amplitudenverlauf einer Love-Mode in einem geschichteten System dargestellt. Die Amplituden deuten das Ausmaß der Materialverschiebungen in den Schichten der verschiedenen Tiefen an. Love-Moden entstehen durch Interferenz von akustischen P- und S-Körperschallwellen in Körpern mit geschichtet variierender Schallgeschwindigkeit. Die Energie der Love-Mode ist oberflächennah lokalisiert, wenn die Schallgeschwindigkeit zur Oberfläche hin abnimmt.

Fig. 2 zeigt ein Magnetfeldsensorelement mit einer Verzögerungsstrecke nach der Lehre der Erfindung. Das Substrat besteht aus einem Piezoelektrikum mit einer geeignet orientierten Oberfläche, so dass bei Beaufschlagung mit einem entlang der Substratebene gerichteten, elektrischen Feld vorzugsweise auch nur Kräfte in der Substratebene ausgeübt werden. Wie bereits erwähnt, kommen hierfür AT und ST Schnitte von Quarz oder auch 36°YX Schnitte von Lithiumniobat oder Lithiumtantalat in Frage. Der Stand der Technik kennt jedoch noch viele andere Alternativen; die Erfindung ist nicht auf die genannten Beispiele beschränkt. Weiterhin zeigt Fig. 2 eine Verzögerungsstrecke der Länge L, an deren beiden Enden je ein Paar von ineinandergreifenden Interdigitalelektroden auf dem Substrat angeordnet ist. Eine IDE kann aus jedem elektrischen Leitermaterial gebildet sein, beispielsweise aus einem Metall, das auch unter Vibrationsbedingungen gut am Substrat haftet. Vorzugsweise sind die IDE aus Aluminium oder Gold gebildet.

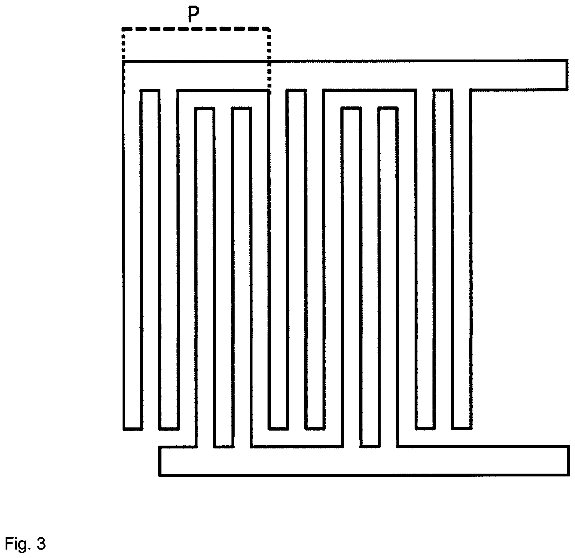

Jede einzelne IDE weist eine Mehrzahl von Fingern auf, deren Anordnung sich in einem regelmäßigen Abstand wiederholt. Dieser Abstand wird gängig als die Periodenlänge p der IDE bezeichnet. Bei SAW-Sensoren kommen unterschiedlich ausgestaltete IDE zum Einsatz, beispielsweise ein in Fig. 3 skizziertes Doppelfinger-IDE-Paar. Die Periodenlänge p ist zur Verdeutlichung auch dort angezeigt.

Der kleinste Abstand zweier Finger eines IDE-Paares ist in Fig. 2 mit a bezeichnet. Er bestimmt die Strecke, über die die an den IDE anliegende Spannung abfällt, und somit die auf das Piezosubstrat wirkende elektrische Feldstärke. Die Breite der IDE-Finger ist in Fig. 2 ebenfalls zu a eingerichtet. Die überlappende Länge der ineinandergreifenden IDE-Finger eines Paares ist als Apertur A bezeichnet und beschreibt die Breite des Anregungsbereichs, in dem die SAW erzeugt wird.

In der Anordnung der Fig. 2 ist vorgesehen, eines der beiden IDE-Paare mit einem periodischen, elektrischen Spannungssignal zu beaufschlagen und dadurch periodische Kontraktions- und Expansionsbewegungen im Substrat auszulösen. Üblich besitzt die Anregungsspannung einen zeitlich harmonischen Verlauf und eine einzelne vorbestimmte Frequenz, z.B. U(t) = U0 * sin(2π f*t). Den größten Energieeintrag in das Substrat erzielt man bei resonanter Anregung, also bei jener Frequenz f_{R}, für die V_{S} = p * f_{R} gilt. Dabei ist mit V_{S} die Scherwellengeschwindigkeit im Substrat gemeint, die sich auf die vorwiegend angeregten Schwingungsmoden bezieht. Sie kann experimentell durch einen Frequenzsuchlauf ermittelt werden.

Ein Anteil der am mit Spannung versorgten IDE-Paar generierten akustischen Welle erreicht das andere IDE-Paar und wird dort als Ausgangsspannungssignal detektiert.

In Fig. 2 ist ein rechteckiger Materialstreifen ungefähr der Länge L und Breite A dargestellt, der entlang der Verzögerungsstrecke zwischen den IDE-Paaren angeordnet ist. Der Streifen könnte sich auch bis über die IDE erstrecken. Sein Zweck ist die Aufnahme eines Großteils der Energie der generierten akustischen Welle und die Führung der Welle vom anregenden zum detektierenden IDE-Paar. Die Welle wird kanalisiert, und die Anordnung aus zwei IDE-Paaren und einem die beiden "verbindenden" Materialstreifen wird auch als SAW-Channel bezeichnet.

Die Erfindung betrifft im Wesentlichen die Auswahl einer günstig orientierten Substratfläche und den Aufbau des Materialstreifens, der aus zwei Schichten aufgebaut ist.

Die erste Schicht besteht aus einem nicht-magnetischen, elektrisch nicht-leitenden Material, dessen Scherwellengeschwindigkeit kleiner ist als die Scherwellengeschwindigkeit V_{S} im Substrat. Dabei soll ihre Dicke erfindungsgemäß zwischen 10 % und 30 % der Periodenlänge p der IDE betragen. In diesem Fall ist sie geeignet, die Schwingungsenergie aus dem Substrat aufzunehmen und in sich zu konzentrieren; es bilden sich Love-Moden wie in Fig. 1 aus. Diese erste Schicht wird hier als Führungsschicht bezeichnet. Sie kann beispielsweise aus den Materialien Siliziumdioxid, Zinkoxid, Polydimethylsiloxan, Polymethylmethacrylat (PMMA) und Polyimid gebildet und dabei auch insbesondere als ein mehrlagiges Schichtsystem aus einer Kombination dieser Materialien ausgestaltet sein. Weitere Materialien sind möglich und an sich bekannt. Die Auswahl richtet sich nach dem verwendeten Substrat.

Die zweite Schicht ist auf der ersten angeordnet und besteht aus einem magnetostriktiven Material. Hierbei kommen sowohl metallische als auch nicht-leitende Materialien in Betracht, die einen hohen ΔE-Effekt des Schermoduls, d.h. Änderung der Schermoduls pro Magnetfeld aufweisen. Auf das Ausmaß der Magnetostriktion kommt es nicht an, wobei ein Material, das große Längenänderungen im veränderlichen Magnetfeld zeigt als bevorzugt angesehen werden kann, da der Effekt des Magnetfeldes auf die Wellenausbreitung in solchen Materialien in der Regel größer sein sollte. Vorrangig ist aber das Ausmaß des ΔE-Effekts für den Schermodul, denn die elastischen Eigenschaften bestimmen die Ausbreitungsgeschwindigkeit akustischer Wellen. Je stärker sich diese unter Einwirkung eines externen Feldes ändern, desto größer ist die Sensitivität des Sensorelements. Beispiele für ein geeignetes Material sind das metallische Glas FeCoSiB, amorphes FeGaB oder Multilagen aus TbFe und FeCo.

Hinsichtlich der Wahl der Dicke der magnetostriktiven Funktionsschicht sind Kompromisslösungen zu suchen. Folgende Argumente sollte man berücksichtigen:
Es ist zunächst anzumerken, dass die Schichtdicke sehr klein sein kann, etwa nur wenige 100 Nanometer. Dies ist vorteilhaft hinsichtlich des Herstellungsaufwandes, beispielsweise wenn sie in Gestalt eines Schichtsystems aufgebaut werden soll, das die magnetische Anisotropie über die Exchange Bias Wechselwirkung nach der Lehre der Druckschrift EP 2 538 235 B1 einrichtet. Die Verwendung eines Schichtsystems gebildet aus aufeinander abgeschiedene Schichten aus einem antiferromagnetischen Material und aus einem ferromagnetischen Material in einer sich abwechselnden Anordnung als magnetostriktive Funktionsschicht wird als eine bevorzugte Ausgestaltung angesehen.

Andererseits besteht die allgemeine Regel, dass Magnetfelder ein nicht zu kleines Materialvolumen benötigen, um einen messbaren Effekt hervorzurufen. Nicht zuletzt deshalb ist der Sensor von Squire deutlich empfindlicher als die bisherigen, sehr viel kleineren SAW-Sensoren. Dickere Filme generieren wiederum auch mehr Streufeld als dünnere, was der Sensitivität abträglich sein kann.

Der Einfluss eines Magnetfeldes auf die magnetostriktiven Funktionsschicht wird hier über eine Art Love-Wellen-Sensor abgetastet. Üblicherweise werden solche Sensoren als hochempfindliche Waagen eingesetzt, d.h. in einem gewissen Dickenbereich ausgehend von Null kann man von einer - in erster Näherung proportionalen - Signalzunahme mit wachsender Schichtdicke ausgehen. Für große Schichtdicken wird hier aber ein Sättigungseffekt erwartet.

Es kommen nach derzeitiger Einschätzung der Erfinder für die magnetostriktive Schicht Dicken zwischen etwa 100 Nanometer und einigen Mikrometer, beispielsweise 10 µm oder gar 20 µm durchaus in Frage.

In Fig. 2 ist der Materialstreifen umfassend die Führungsschicht und die magnetostriktive Schicht mit der Bezeichnung MS abgekürzt. Dies hebt hervor, dass hier die Messung von Magnetfeldern im Vordergrund steht. Wie zuvor gesagt, sind SAW-Sensoren bekannt, die eine Führungsschicht in der hier beschriebenen Art aufweisen, um Love-Moden an der Oberfläche auszubilden. Diese Moden werden empfindlich gestört, wenn sich zusätzliche Massen an die Oberflächen anlagern. Die heute bekannten Anwendungen von Love-Wave Sensoren liegen in der Wägung sehr kleiner Massen und in der Messung von Viskositäten. Sie kommen üblich in Kontakt mit einem Fluid zum Einsatz, und es zählt zu den Vorteilen der Love-Moden, dass sie dabei kaum Schallenergie an das Fluid abgeben.

Das hier beschriebene Sensorelement mit einer magnetostriktiven Funktionsschicht auf einer Führungsschicht ist nach Kenntnis der Erfinder der erste Versuch, mit Love-Moden in einem SAW-Sensor auch Magnetfelder zu bestimmen.

Es soll nachfolgend zunächst die Herstellung eines erfindungsgemäßen Magnetfeldsensorelements im Labor als Ausführungsbeispiel beschrieben werden.

Das piezoelektrische Substrat mit einer Orientierung, die die Entstehung von mechanischen Scherwellen zulässt, liegt als Wafer von 4 Zoll = 10,16 cm Durchmesser vor. Es handelt sich hier um ST-Quarz, also um einen um 42°45' +/-6' um die Z-Achse verkippten Y-Schnitt mit einer Dicke von 500 µm. Gegebenenfalls ist vor der Beschichtung eine Reinigung im Ultraschallbad mit Aceton und anschließendem Spülen mit Isopropanol und deionisiertem Wasser durchzuführen. Die Scherwellengeschwindigkeit von Quarz beträgt laut Literatur etwa 5050 m/s.

Auf das saubere Substrat wird zunächst eine 12 nm dicke Chromschicht als Haftvermittler und darauf eine 300 nm dicke Goldschicht für die Interdigitalelektroden mittels Magnetronsputtern abgeschieden. Eine weitere 12 nm dicke Chromschicht dient als Schutzschicht für die Kontakte.

Hiernach werden die Strukturen für die IDEs mittels Lithographieverfahren auf einen positiven Fotolack übertragen, welcher im nächsten Schritt als Ätzmaske genutzt wird. Dabei ist die Ausrichtung des Quarzwafers zur Maske zu beachten. Für die gewählten Quarzwafer verläuft die Wellenausbreitungsrichtung parallel zur Flachseite des Wafers. Die Chrom-Gold-Schicht wird mittels lonenstrahlätzung von den unmaskierten Bereichen entfernt, um die IDE Strukturen auf die Chrom-Gold-Schicht übertragen. In diesem Beispiel werden IDEs als Doppelfinger-Strukturen, vgl. Fig. 3, mit einer Periodenlänge p = 28 Mikrometer erzeugt. Die Fingerbreite beträgt a= 3,5 Mikrometer, die Apertur beträgt A = 1680 Mikrometer und der Abstand der IDE-Paare auf dem Wafer ist L = 3840 Mikrometer, vgl. Fig. 2.

Nach der Ätzung wird der Fotolack in einem Ultraschallbad mit NMP (N-Methyl-2-pyrrolidon) bei 70°C entfernt. Anschließend erfolgt eine weitere Säuberung im Ultraschallbad mit Aceton und Isopropanol, jeweils bei 45°C. Der Wafer wird abschließend noch einmal mit frischem Isopropanol und mit deionisiertem Wasser gespült und in einer Trockenschleuder getrocknet.

Die Abscheidung der Führungsschicht erfolgt mittels plasmaunterstützter chemischer Gasphasenabscheidung. Es wird eine 4,5 µm dicke amorphe Siliziumoxidschicht über den gesamten Wafer abgeschieden. Die Scherwellengeschwindigkeit der Führungsschicht liegt dann bei etwa 2850 m/s. Anschließend wird diese wieder mit einem Lithographieverfahren maskiert und die Führungsschicht mit reaktivem lonenätzen strukturiert. Um eventuelle Rückstände nach dem reaktiven lonenätzen vollständig zu entfernen, kann ein weiterer Ätzschritt, beispielsweise nasschemisch mit gepufferter Flusssäure, durchgeführt werden. Überreste der elektrisch isolierenden Siliziumoxidschicht werden dadurch schnell entfernt und ein elektrischer Kontakt zu den IDEs kann hergestellt werden.

Nach der Strukturierung bedeckt die Führungsschicht die komplette Verzögerungslinie und beide IDE Strukturen. Durch die Ätzung werden die Kontakte der IDEs freigelegt, mit welchen das Signal erzeugt und ausgelesen wird. Außerdem wird auf der der Verzögerungslinie abgewandten Seite der IDEs eine gewinkelte Abschlusskante strukturiert. Diese sorgt dafür, dass die erzeugte Welle, welche sich in beiden Richtungen der IDE Strukturen ausbreitet, nicht an der gerade Kante der Führungsschicht reflektiert wird und es so zu Interferenzen innerhalb der Verzögerungslinie zwischen der reflektierten und der unreflektierten Welle kommen kann.

An die Strukturierung anschließend findet wieder eine Entlackung wie oben bereits erläutert statt.

Auf die Führungsschicht wird die magnetostriktive Funktionsschicht, hier 200 Nanometer FeCoSiB, abgeschieden. Diese kann entweder über ein Lift-off Verfahren oder über lonenstrahlätzen strukturiert werden. Für das Lift-off Verfahren wird zuerst mittels Lithographie eine Fotolackmaske erzeugt und anschließend die magnetische Schicht mittels Magnetronsputtern abgeschieden.

Das wie vorbeschrieben erzeugte Sensorelement wird weiter unten hinsichtlich seiner Empfindlichkeit in Bezug auf ein externes Magnetfeld untersucht und beurteilt.

Zuvor sollen noch einige bevorzugte Fortbildungen des Sensorelements vorgestellt werden.

Alternativ oder zusätzlich ist es für Magnetfeldgradientenmessungen eine vorteilhafte Ausgestaltung eines Sensorelements, wenn es eine Mehrzahl von SAW-Channels, nebeneinander aufweist, derart, dass alle Verzögerungsstrecken parallel zueinander ausgerichtet sind. Auf diese Weise werden auch Änderungen des Magnetfeldes senkrecht zur Richtung der Verzögerungsstrecke simultan detektierbar.

Besonders bevorzugt kann man die beiden vorgenannten Ansätze ohne Probleme kombinieren und so relativ kostengünstige Magnetfeldsensorelemente mit einer Magnetfeldgradientensensitivität entlang zweier Achsen schaffen.

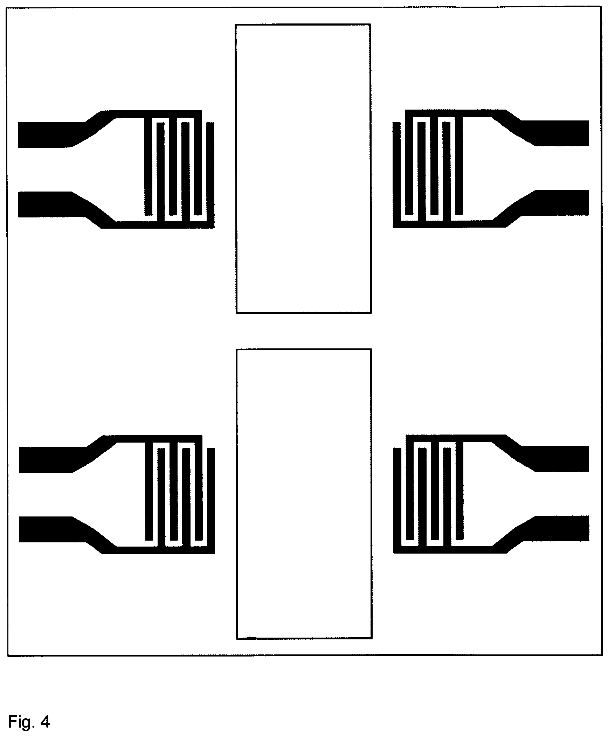

Eine weitere vorteilhafte Ausgestaltung besteht darin, das Magnetfeldsensorelement als Magnetfeldsensordoppelelement mit einer intrinsischen Kompensation für Temperatureinflüsse auszustatten. Dazu wird vorgeschlagen, wie skizziert in Fig. 4, das Sensorelement mit zwei separaten, parallel angeordneten und annähernd gleichen SAW-Channels zu versehen, wobei der erste Channel eine magnetostriktive Funktionsschicht und der zweite Channel eine nichtmagnetostriktive Schicht auf der bei beiden Channels gleichen Führungsschicht umfasst. Bei gleichen lateralen Abmessungen und Schichtdicken sollen die verschiedenen Schichten der beiden Channels - möglichst - gleiche akustische Eigenschaften aufweisen. Durch die fehlende magnetostriktive Funktionsschicht zeigt der zweite Channel allerdings keine Abhängigkeit von Magnetfeldern und kann als Temperaturreferenz benutzt werden.

Anders ausgedrückt wird ein temperaturkompensiertes Magnetfeldsensordoppelelement vorgeschlagen, das ein vorbeschriebenes Magnetfeldsensorelement und zusätzlich noch ein dem Magnetfeldsensorelement benachbart angeordnetes Referenzsensorelement umfasst. Das Referenzsensorelement ist hinsichtlich Substrat, Interdigitalelektroden und Führungsschicht mit dem Magnetfeldsensorelement baugleich, und besitzt eine eigene Verzögerungsstrecke parallel zur Verzögerungsstrecke des Magnetfeldsensorelements, entlang der eine Funktionsschicht des Referenzsensorelements angeordnet ist. Dabei soll die Funktionsschicht des Referenzsensorelements die gleichen akustischen Eigenschaften wie die Funktionsschicht des Magnetfeldsensorelements aufweisen und aus einem nicht-magnetostriktiven Material gebildet sein. Das temperaturkompensierte Magnetfeldsensordoppelelement weist somit stets zwei Kanäle auf.

Die eigentliche Messung erfolgt dann als Differenzmessung zwischen den beiden Kanälen. Unter der i.A. gut erfüllten Annahme, dass beide Channels die gleiche Änderung der Temperatur aufweisen, würden entsprechende temperaturbedingte Phasenänderungen in beiden Channels in vergleichbarer Weise auftreten, so dass sie durch eine Differenzmessung kompensiert werden würden. Ebenso würden alle anderen Signale abgesehen von der Phasenänderung die durch das Magnetfeld hervorgerufen wurde, kompensiert. Es bleibt als Signal des Sensorelements also nur noch der Beitrag des Magnetfeldes, unabhängig von der Umgebungstemperatur.

Wird die gleiche Quelle zur Ansteuerung der beiden Sensoren verwendet, weisen beide zudem das gleiche Phasenrauschen auf, das durch die Differenzmessung ebenfalls kompensiert werden würde.

Eine weitere Ausgestaltung des Sensorelements kann darin bestehen, das Element als einen SAW-Resonator auszubilden.

Der Aufbau des Magnetfeldsensors als SAW-Resonator ist gekennzeichnet durch eine Elektrodenstruktur und ein Volumen damit verbundener Materialschichten, in dem Energie gespeichert wird. Bei seiner Resonanzfrequenz zeigt ein SAW-Resonator eine starke Änderung des Phasenwinkels des Reflexions- oder Transmissionssignals und ist dabei extrem schmalbandig in der Frequenzbandbreite.

Bei SAW Resonatoren unterscheidet man zwischen Reflexions- und Transmissionsresonatoren. Eine mögliche Form eines Reflexionsresonators ist in Draufsicht in Figur 5 gezeigt. Das mit IDE bezeichnete Elektrodenpaar besitzt die Periodenlänge p, die Länge Lt und die Apertur w und dient als Ein- und Ausgang. Ist der gegenüber liegende zweite Anschluss geerdet, lassen sich Signale an den Elektroden IDE unsymmetrisch gegen Erde einspeisen bzw. abnehmen. Die akustische Welle wird durch die IDE Struktur in der Führungsschicht FS angeregt und breitet sich nach links und rechts aus. Sie wird an den Reflektoren R der Länge Lr zurückgeworfen, wodurch sich im Laufraum der Länge Lrr eine stehende Welle bildet. Die Länge des Laufraums und damit die Resonanzfrequenz verändern sich, sobald ein Magnetfeld auf die Funktionsschicht MS des Sensors einwirkt. Die damit verbundene Phasenverschiebung wird gemessen. Die Reflektoren R bestehen beispielsweise aus an den Längsseiten elektrisch kurzgeschlossenen oder auch leerlaufenden, hier mit der halben Periodenlänge p beabstandeten Metallstegen. Bei einem Transmissionsresonator ist die mittlere IDE-Struktur doppelt vorhanden, so dass Ein-und Ausgang voneinander entkoppelt werden können.

Der Aufbau des Sensors als Verzögerungsleitung kann ebenfalls in Transmission realisiert, in eine Ringleitung integriert und ebenfalls als resonantes Element in einem Oszillatorkreis verwendet werden. Für die Führungsschicht und die magnetostriktive Schicht in einem SAW Resonator gelten dieselben Voraussetzungen wie für den Aufbau als Verzögerungsleitung.

Somit kann die Erfindungsaufgabe nach demselben erfinderischen Konzept gelöst werden mit einem Magnetfeldsensorelement umfassend ein piezoelektrisches Substrat mit vorbestimmter Scherwellengeschwindigkeit V_{S}, wenigstens ein auf dem Substrat in einem Laufraum angeordnetes Paar von Interdigitalelektroden mit einer Periodenlänge p von wenigstens 10 Mikrometern, wenigstens zwei an den Enden des Laufraums angeordnete Reflektoren für akustische Scherwellen der Wellenlänge p, eine auf dem Substrat entlang des Laufraums angeordnete, nicht-magnetische, elektrisch nicht-leitende Führungsschicht und eine auf der Führungsschicht angeordnete magnetostriktive Funktionsschicht, wobei die Scherwellengeschwindigkeit in der Führungsschicht kleiner als V_{S} ist, dadurch gekennzeichnet, dass das Substrat orientiert ist zur Erzeugung und Propagation von mechanischen Scherwellen bei Beaufschlagung wenigstens eines Interdigitalelektrodenpaares mit einer zeitlich periodischen, elektrischen Spannung im Bereich der Frequenz V_{S}/p und die Dicke der Führungsschicht mindestens 10 % und höchstens 30 % der Periodenlänge p der Interdigitalelektroden beträgt.

Alle vorgenannten Ausgestaltungen des erfindungsgemäßen Magnetfeldsensors können auch in einer größeren Anzahl auf ein und demselben Substrat angeordnet werden, weil sie mit den bekannten Methoden der Dünnschichttechnologie herstellbar sind. Wie bereits erwähnt, ist die benachbarte Anordnung mehrerer Sensoren schon deshalb vorteilhaft, weil eine solche Anordnung auch das Messen von Gradienten des Magnetfeldes gestattet.

Als eine bevorzugte Ausgestaltung wird ein Magnetfeldgradientensensorelement vorgeschlagen, das wenigstens zwei baugleiche Magnetfeldsensorelemente - nach irgendeiner der vorgenannten Ausgestaltungen - mit parallel ausgerichteten Verzögerungsstrecken oder Laufräumen der Magnetfeldsensorelemente senkrecht zu einer gemeinsamen Mittelachse aufweist. Die Mittelachse entspricht dann der Achse, entlang der ein magnetischer Gradient bestimmt werden kann.

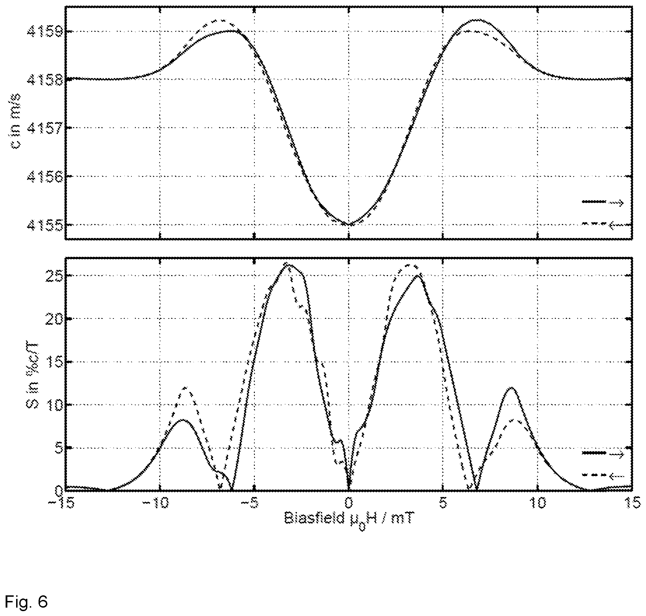

Zur abschließenden Bewertung der Empfindlichkeit eines Magnetfeldsensorelements nach der Lehre dieser Erfindung werden an dem Sensorelement des Ausführungsbeispiels sehr genaue Phasenmessungen vorgenommen, aus denen die Scherwellengeschwindigkeit in Abhängigkeit des extern anliegenden Magnetfeldes errechnet wird. Das Resultat ist in Fig. 6 graphisch dargestellt.

Die obere Graphik von Fig. 6 gibt die absolute Scherwellengeschwindigkeit in dem System aus Führungsschicht und magnetostriktiver Funktionsschicht an, die sich aus den Messsignalen der IDE-Anordnung ergibt. Die jeweilige magnetische Flussdichte ist auf der Abszisse aufgetragen. Hysterese in der magnetischen Funktionsschicht bewirkt, dass sich zwei Kurven ergeben, abhängig davon, ob man das Magnetfeld von der positiven zur negativen Richtung oder umgekehrt durchläuft. Die untere Graphik von Fig. 6 zeigt die Ableitungen der oberen Kurven, die als Empfindlichkeit des Sensors zu verstehen sind. Die maximale Empfindlichkeit weist der Sensor bei einem Bias-Feld von etwa 3 mT auf, wo sie ungefähr 25 % der Scherwellengeschwindigkeit pro Tesla beträgt. Dieser Wert lässt sich sehr gut vergleichen mit der Arbeit von Zhou et al., aus der sich 0,25 % der Scherwellengeschwindigkeit pro 100 Oersted für einen SAW-Sensor ohne jegliche Führungsschicht ablesen lässt.

Bei Zhou et al. wird allerdings von einem ΔE-Effekt der Größenordnung 20 % ausgegangen, während das Sensorelement des Ausführungsbeispiels in dieser Hinsicht noch nicht optimiert worden ist; es besteht somit noch deutliches Verbesserungspotenzial, das ausgeschöpft werden kann. Gleichwohl ist schon der Prototyp von ähnlich guter Qualität wie der Sensor von Zhou et al. mit seinen optimierten Materialeigenschaften.

In der Publikation "Sensitivity analysis for Love mode acoustic gravimetric sensors" von Z. Wang, J. D. N. Cheeke, and C. K. Jen, Applied Physics Letters 64, 2940 (1994); doi: 10.1063/1.111976 heißt es wörtlich: "This result means that the maximum sensitivity of a Love mode sensor, made by a PMMA film overlaid on ST cut quartz, can be about 20 times larger than that of a STW sensor on the same substrate and operating at a similar frequency." Obwohl darauf hingewiesen wird, dass das PMMA in diesen Dimensionen hohe Verluste aufweist, zeigt diese Berechnung das große Potenzial von Love-Wave-Sensoren als hochempfindliche Waagen. Diese Einschätzung wird auch durch "Design and properties of quartz-based Love wave acoustic sensors incorporating silicon dioxide and PMMA guiding layers" by Geoffrey L Harding and Jia Du, Smart Mater. Struct. 6 (1997) 716-720 bestätigt. In der dortigen Tabelle 1 zeigen die Autoren, dass für eine Frequenz von etwa 120 MHz die Massenempfindlichkeit von SH-SAWs von 14 cm²/g auf 519 cm²/g für einen bezüglich der Führungsschicht optimierten Love-Wave Sensor gesteigert werden kann.

Diese Empfindlichkeitssteigerung kann direkt auch für Magnetfeldsensoren genutzt werden, da sie auf eine entsprechende Konzentration der akustischen Wellen auf den Bereich der zu messenden Schicht zurückzuführen ist. Bei Verwendung gleich dicker magnetostriktiver Funktionsschichten mit dem gleichen ΔE-Effekt für das Schermodul führt eine optimale Führungsschicht somit zu einer mindestens um eine Größenordnung höheren Empfindlichkeit im Vergleich zu Scherwellen SAWs ohne Führungsschicht.

Das erfindungsgemäße Vorsehen einer ausreichend dicken Führungsschicht im geeigneten Verhältnis zur angeregten Love-Moden-Wellenlänge erscheint als generelles Schlüsselkonzept für die Nutzbarmachung von SAW-Sensoren zur Detektion kleiner magnetischer Felder über einen großen Frequenzbereich von wenigen Hertz bis in den hohen Kilohertzbereich. Dies gestattet sowohl das Erfassen von Stromsystemen mit hoher intrinsischer Frequenzbandbreite als auch insbesondere das Detektieren biomagnetischer Felder.

## Patentansprüche

1. Magnetfeldsensorelement umfassend ein piezoelektrisches Substrat mit vorbestimmter Scherwellengeschwindigkeit V_{S}, zwei auf dem Substrat an den Enden einer Verzögerungsstrecke angeordnete Paare von Interdigitalelektroden mit einer Periodenlänge p von wenigstens 10 Mikrometern, eine auf dem Substrat entlang der Verzögerungsstrecke angeordnete, nicht-magnetische, elektrisch nicht-leitende Führungsschicht (FS) und eine auf der Führungsschicht angeordnete magnetostriktive Funktionsschicht (MS),
wobei die Scherwellengeschwindigkeit in der Führungsschicht kleiner als V_{S} ist, **dadurch gekennzeichnet, dass**
a.) das Substrat orientiert ist zur Erzeugung und Propagation von mechanischen Scherwellen bei Beaufschlagung wenigstens eines Interdigitalelektrodenpaares mit einer zeitlich periodischen, elektrischen Spannung im Bereich der Frequenz V_{S} /p und
b.) die Dicke der Führungsschicht mindestens 10 % und höchstens 30% der Periodenlänge p der Interdigitalelektroden beträgt,
wobei die Dichte des Materials der Führungsschicht kleiner als die Dichte des Substratmaterials ist
und zu den zwei Paaren von Interdigitalelektroden an den Enden der Verzögerungsstrecke ein drittes Paar von Interdigitalelektroden (IDE) in der Mitte der Verzögerungsstrecke angeordnet ist.

2. Magnetfeldsensor nach Anspruch 1,
**dadurch gekennzeichnet, dass**
das Substrat aus einem Material aus der Gruppe umfassend Quarz, Lithiumniobat und Lithiumtantalat gebildet ist und die Interdigitalelektroden auf vorbestimmten Schnittflächen angeordnet sind.

3. Magnetfeldsensor nach einem der vorangehenden Ansprüche,
**dadurch gekennzeichnet, dass**
die Führungsschicht aus wenigstens einem Material aus der Gruppe umfassend Siliziumdioxid, Zinkoxid, Polydimethylsiloxan, Polymethylmethacrylat (PMMA) und Polyimid gebildet ist.

4. Magnetfeldsensorelement nach einem der vorangehenden Ansprüche,
**dadurch gekennzeichnet, dass**
die magnetostriktive Funktionsschicht eine Schichtdicke zwischen 100 Nanometern und 10 Mikrometern aufweist.

5. Magnetfeldsensorelement nach einem der vorangehenden Ansprüche,
**dadurch gekennzeichnet, dass**
die magnetostriktive Funktionsschicht als ein Schichtsystem gebildet ist, dass aufeinander abgeschiedene Schichten aus einem antiferromagnetischen Material und aus einem ferromagnetischen Material in einer sich abwechselnden Anordnung umfasst.

6. Magnetfeldsensordoppelelement aufweisend ein Magnetfeldsensorelement nach einem der vorangehenden Ansprüche
**gekennzeichnet durch**
ein dem Magnetfeldsensorelement benachbart angeordnetes Referenzsensorelement, das hinsichtlich Substrat, Interdigitalelektroden und Führungsschicht mit dem Magnetfeldsensorelement baugleich ist und eine Verzögerungsstrecke parallel zur Verzögerungsstrecke des Magnetfeldsensorelements aufweist, wobei die Funktionsschicht des Referenzsensorelements die gleichen akustischen Eigenschaften wie die Funktionsschicht des Magnetfeldes aufweist und aus einem nicht-magnetostriktiven Material gebildet ist.

7. Magnetfeldgradientensensorelement, aufweisend wenigstens zwei baugleiche Magnetfeldsensorelemente nach einem der vorangehenden Ansprüche,
**gekennzeichnet durch**
parallel ausgerichtete Verzögerungsstrecken oder Laufräume der Magnetfeldsensorelemente senkrecht zu einer gemeinsamen Mittelachse.

## Claims

1. A magnetic field sensor element comprising a piezoelectric substrate having a predetermined shear wave velocity V_{S}, two pairs of interdigital electrodes, arranged on the substrate at the ends of a delay section, having a period length p of at least 10 micrometers , a non-magnetic, electrically non-conductive guide layer (FS) arranged on the substrate along the delay section, and a magnetostrictive functional layer (MS) arranged on the guide layer, wherein the shear wave velocity in the guide layer is smaller than Vs ,
**characterized in that**
a.) the substrate is oriented to generate and propagate mechanical shear waves upon applying a temporally periodic electrical voltage to at least one interdigital electrode pair in the range of frequency V_{S} /p, and
b.) the thickness of the guide layer is at least 10% and at most 30% of the period length p of the interdigital electrodes,
wherein the density of the material of the guide layer is lower than the density of the substrate material
and
wherein for each two pairs of interdigital electrodes arranged at the ends of the delay section, a third pair of interdigital electrodes (IDE) is provided in the middle of the delay section.

2. Magnetic field sensor element according to claim 1,
**characterized in that**
the substrate is formed of a material from the group comprising quartz, lithium niobate and lithium tantalate and the interdigital electrodes are arranged on predetermined cut surfaces.

3. Magnetic field sensor element according to any one of the preceding claims,
**characterized in that**
the guide layer is formed of at least one material from the group comprising silicon dioxide, zinc oxide, polydimethylsiloxane, polymethylmethacrylate (PMMA) and polyimide.

4. Magnetic field sensor element according to any one of the preceding claims,
**characterized in that**
the magnetostrictive functional layer has a layer thickness between 100 nanometers and 10 microns.

5. Magnetic field sensor element according to any one of the preceding claims,
**characterized in that**
the magnetostrictive functional layer is formed as a layer system, that comprises successive layers deposited of an antiferromagnetic material and a ferromagnetic material in an alternating arrangement.

6. Magnetic field sensor double element comprising a magnetic field sensor element according to any one of the preceding claims,
**characterized by**
a reference sensor element adjacent to the magnetic field sensor element which is identical in terms of substrate, interdigital electrodes and guide layer with the magnetic field sensor element and has a delay section parallel to the delay section of the magnetic field sensor element, wherein the functional layer of the reference sensor element has the same acoustic properties as the functional layer of the magnetic field and is formed from a non-magnetostrictive material.

7. Magnetic field gradient sensor element comprising at least two identical magnetic field sensor elements according to any one of the preceding claims,
**characterized by**
parallel aligned delay sections or running spaces of the magnetic field sensor elements perpendicular to a common center axis.

## Revendications

1. Elément capteur de champ magnétique comprenant un substrat piézoélectrique ayant une vitesse d'onde de cisaillement prédéterminée V_{S}, deux paires d'électrodes interdigitales, disposées sur le substrat aux extrémités d'une section de retard, ayant une longueur de période p d'au moins 10 micromètres, une couche de guidage non magnétique, électriquement non conductrice (FS) disposée sur le substrat le long de la section de retard, et une couche fonctionnelle magnétostrictive (MS) disposée sur la couche de guidage, dans laquelle la vitesse d'onde de cisaillement dans la couche de guidage est inférieure à V_{S}
**caractérisé en ce que**
a.) le substrat est orienté pour générer et propager des ondes de cisaillement mécaniques lors de l'application d'une tension électrique temporellement périodique à au moins une paire d'électrodes interdigitales dans la gamme de fréquence V_{S} /p, et
b.) l'épaisseur de la couche de guidage est d'au moins 10 % et d'au plus 30 % de la longueur de période p des électrodes interdigitales,
dans lequel la densité du matériau de la couche de guidage est inférieure à la densité du matériau du substrat
et
dans lequel, pour chaque paire d'électrodes interdigitales disposées aux extrémités de la section de retard, une troisième paire d'électrodes interdigitales (IDE) est prévue au milieu de la section de retard.

2. Elément capteur de champ magnétique selon la revendication 1,
**caractérisé en ce que**
le substrat est formé d'un matériau du groupe comprenant le quartz, le niobate de lithium et le tantalate de lithium et les électrodes interdigitales sont disposées sur des surfaces de coupe prédéterminées.

3. Elément capteur de champ magnétique selon l'une quelconque des revendications précédentes,
**caractérisé en ce que**
la couche de guidage est formée d'au moins un matériau du groupe constitué par le dioxyde de silicium, l'oxyde de zinc, le polydiméthylsiloxane, le polyméthacrylate de méthyle (PMMA) et le polyimide.

4. Elément capteur de champ magnétique selon l'une quelconque des revendications précédentes,
**caractérisé en ce que**
la couche fonctionnelle magnétostrictive a une épaisseur de couche comprise entre 100 nanomètres et 10 microns.

5. Elément capteur de champ magnétique selon l'une quelconque des revendications précédentes,
**caractérisé en ce que**
la couche fonctionnelle magnétostrictive est formée comme un système de couches, qui comprend des couches successives déposées d'un matériau antiferromagnétique et d'un matériau ferromagnétique dans une disposition alternée.

6. Elément double de capteur de champ magnétique comprenant un élément capteur de champ magnétique selon l'une quelconque des revendications précédentes,
**caractérisé par**
un élément capteur de référence adjacent à l'élément capteur de champ magnétique qui est identique en termes de substrat, d'électrodes interdigitales et de couche de guidage à l'élément capteur de champ magnétique et qui a une section de retard parallèle à la section de retard de l'élément capteur de champ magnétique, dans lequel la couche fonctionnelle de l'élément capteur de référence a les mêmes propriétés acoustiques que la couche fonctionnelle du champ magnétique et est formée d'un matériau non magnétostrictif.

7. Elément capteur de gradient de champ magnétique comprenant au moins deux éléments capteurs de champ magnétique identiques selon l'une quelconque des revendications précédentes,
**caractérisé par**
des sections de retard ou des espaces de circulation des éléments capteurs de champ magnétique alignés parallèlement et perpendiculaires à un axe central commun.
